# EUROPEAN PATENT SPECIFICATION

(11) **EP 1 344 110 B1**
(45) Date of publication and mention of the grant of the patent: **10.03.2010**
(21) Application number: 00988384.4
(22) Date of filing: 21.12.2000
(51) Int. Cl.: G03F 7/20

(54) **MITIGATION OF RADIATION INDUCED SURFACE CONTAMINATION**
REDUCTION DE LA CONTAMINATION SUPERFICIELLE CAUSEE PAR DES RADIATIONS
ATTENUATION DE LA CONTAMINATION DE SURFACES INDUITE PAR UN RAYONNEMENT

(43) Date of publication of application: 17.09.2003
(73) Proprietor: EUV Limited Liability Corporation, Santa Clara, CA 95052 (US)
(72) Inventor: KLEBANOFF, Leonard, E., Dublin, CA 94568 (US); STULEN, Richard, H., Livermore, CA 94550 (US)
(74) Representative: Pearson, James Ginn
(86) International application number: PCT/US2000/035394
(87) International publication number: WO 2002/052347

(56) References cited:
- US-B1- 6 252 648
- PRUETT C H: "Care and conditioning of optical surfaces for SRS beamlines" VACUUM DESIGN OF ADVANCED AND COMPACT SYNCHROTRON LIGHT SOURCES, UPTON, NY, USA, MAY 1988, no. 171, pages 167-174, XP008000138 AIP Conference Proceedings, 1988, USA ISSN: 0094-243X
- KUNZ R R ET AL: "Experimentation and modeling of organic photocontamination on lithographic optics" JOURNAL OF VACUUM SCIENCE & TECHNOLOGY B (MICROELECTRONICS AND NANOMETER STRUCTURES), MAY 2000, AIP FOR AMERICAN VACUUM SOC, USA, vol. 18, no. 3, pages 1306-1313, XP002188756 ISSN: 0734-211X

## Description

### BACKGROUND OF THE INVENTION

The present invention is directed generally to a process for mitigating degradation and contamination of surfaces caused by radiation induced breakdown of molecules and their subsequent reaction and/or deposition on these surfaces. More particularly, the process disclosed herein is directed to protection of the surfaces of components of a lithographic stepper, such as the mask and imaging optics, from the consequences of radiation induced molecular breakdown.

Photolithography is a well-known technique for applying patterns to the surface of a workpiece, such as a circuit pattern to a semiconductor chip or wafer. This technique has the advantage of being able to faithfully reproduce small and intricate patterns. Traditional photolithography involves applying electromagnetic radiation to a mask having openings formed therein (transmission mask) such that the light or radiation that passes through the openings is applied to a region on the surface of the workpiece that is coated with a radiation-sensitive substance, e.g., a photoresist. The mask pattern is reproduced on the surface of the workpiece by removing the exposed or unexposed photoresist. However, the capabilities of conventional photolithographic techniques have been severely challenged by the need for circuitry of increasing density and higher resolution features. The demand for smaller feature sizes has inexorably driven the wavelength of radiation needed to produce the desired pattern to ever-shorter wavelengths. As the wavelength of the applied radiation is made shorter the energy of the radiation becomes greater to the point where the radiation can cause the decomposition of molecules adsorbed on or proximate to a surface to produce reactive species that can attack, degrade, or otherwise contaminate the surface.

While short wavelength radiation can directly dissociate molecules, secondary electrons, created by the interaction of this radiation with surfaces, are the primary agents for molecular dissociation. Low energy (5-10 eV) secondary electrons are known to be very active in breaking chemical bonds by direct ionization of adsorbed molecules or by electron attachment, wherein a secondary electron binds to a molecule producing a reactive negative ion that then de-excites to a dissociated product. Any type of radiation (photons, electrons, ions, and particles) that is energetic enough to liberate electrons can create secondary electrons; typically, energies of about 4-5 eV are required. Consequently, radiation induced contamination, i.e., contamination of surfaces by reactive species produced by secondary electrons originating from radiative interactions, will most certainly occur in lithographic processes that use energetic radiation such as: extreme ultraviolet lithography (photon energy of about 100eV), projection electron lithography (electron energy of about 50-100 keV), ion beam lithography (ion energy >10keV), 193 nm lithography (photon energy of about 6.4 eV) and 157 nm lithography (photon energy of about 7.9 eV). Thus, the potential for contamination of critical lithographic components, such as masks and optical surfaces, and degradation of their operational capability is present in all the advanced lithographic processes.

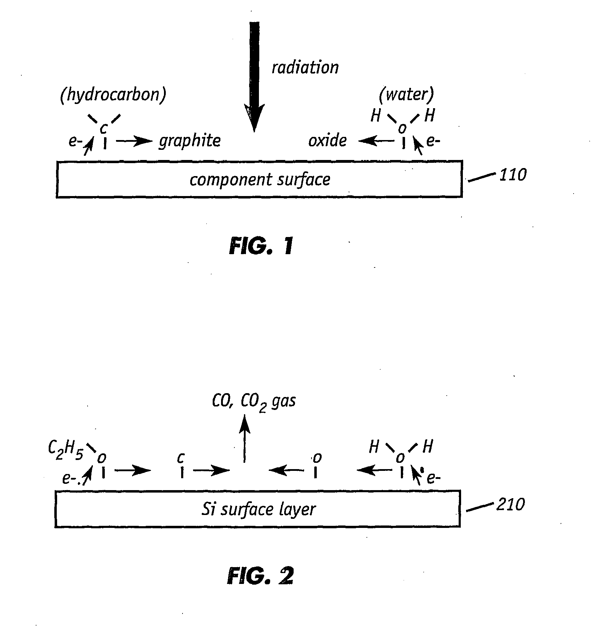

A mechanism for the contamination of surfaces having gaseous species adsorbed thereon and exposed to an incident flux of radiation is illustrated schematically in Fig. 1. Here, surface 110 has both hydrocarbon and water molecules adsorbed thereon. The term "hydrocarbon" can include any carbon containing species. Exposure to a radiation flux causes secondary electrons to be emitted from surface 110 that can dissociate the adsorbed hydrocarbon molecules to form reactive carbon fragments that can form a graphite layer on the surface. By way of example, exposure of a Si-terminated Mo/Si multilayer mirror to a flux density of about 330 mW/mm² of 13.4 nm radiation at a background pressure of 1x10⁻⁷ Torr for about 45 hours results in the growth of a layer of graphitic carbon having a thickness of about 230 Å. The graphitic carbon film, produced by the secondary-electron-induced dissociation of hydrocarbon molecules adsorbed on the surface from this environment reduced mirror reflectivity from 66% to 12%, a loss in reflectivity that would render the multilayer mirror inoperable in a lithographic stepper.

Similarly, secondary electrons emitted from surface 110 in response to the radiation flux can dissociate adsorbed water molecules to form reactive oxygen species that can oxidize a surface to form an oxide film that can degrade the reflectivity of a mirror by absorption of radiation. Thus, oxidation resulting from radiation induced dissociation of water molecules can catastrophically and irreversibly damage optical surfaces. By way of example, exposure of a Si-terminated Mo/Si multilayer mirror to a flux density of about 330 mW/mm² of 13.4 nm radiation and 1x10⁻⁷ Torr of water vapor for about 24 hours results in the growth of a layer of SiO₂. This SiO₂ layer, which cannot be removed without damaging the Mo/Si multilayer structure, caused reflectivity to be reduced from 66% to 59%, a result that is unacceptable for operational purposes.

Accordingly, what is required is a process for eliminating or significantly mitigating contamination and/or degradation of surfaces, and particularly surfaces of critical lithographic components, exposed to radiation in the presence of common contaminants such as water vapor. This is especially true for the emerging lithographic processes that use shorter wavelength and thus higher energy radiation because of the significant potential for degrading critical components and the extreme sensitivity of these components to small changes in surface properties. "Care and conditioning of optical surfaces from SRS beamlines" by C H Pruett (Vacuum Design of Advanced and Compact Synchrotron Light Sources, Upton, New York, USA, May 1988, no. 171, pages 167-174, AIP Conference Proceedings, 1988, USA ISSN: 0094-243X) describes in situ cleaning of X-ray or EUV beamlines with molecular oxygen wherein the introduction of gaseous oxygen or air into the beamline while irradiating the surface to be cleaned with the beam reduces carbon contamination. Similarly, "Experiment and modelling of organic photocontamination on lithographic optics" by RR Kunz et. al. (Journal of Vacuum Science and Technology B (Microelectronics and Nanometer Structures), May 2000, AIP for American Vacuum Society, USA, vol. 18, no. 3, pages 1306-1313, ISSN: 0734-211X) describes the photodeposition of organic films on substrates irradiated in the presence of hydrocarbons.

### SUMMARY OF THE INVENTION

It is an object of the present invention to provide a process for mitigating or eliminating contamination of surfaces by common, adventitious atmospheric molecular compounds dissociated by exposure to a radiative flux.

It is a further object to provide a process that operates effectively at subatmospheric pressures.

In the inventive process disclosed herein a gas or a mixture of gases is introduced into the environment of a surface (s) to be protected. The choice of the gaseous species to be introduced is dependent upon the contamination as well as the ability of the gaseous species to bind to the surface to be protected.

The latter criterion is invoked so that secondary electrons emitted from the surface in response to incident radiation can dissociate the adsorbed species.

When the surface and associated bound species are exposed to radiation, reactive species are formed that react with surface contaminants such as oxide films to form volatile products (e. g., CO, CO2) which desorb from the surface.

### BRIEF DESCRIPTION OF THE DRAWINGS

Figure 1 illustrates schematically a process resulting in surface contamination.
Figure 2 illustrates schematically an embodiment of the present invention.
Figure 3A depicts the oxidation of a Si surface exposed to electron beam irradiation and water vapor.
Figure 3B shows mitigation of oxidation caused by the addition of ethanol.
Figure 4 shows the effect of water vapor and ethanol on a Si surface exposed to EUV radiation.

### DETAILED DESCRIPTION OF THE INVENTION

The present invention is directed to a process for mitigating or eliminating contamination and/or degradation of surfaces having common, adventitious atmospheric contaminants adsorbed thereon and exposed to energetic radiation. These contaminants can include such species as water vapor that can be inherently present in the atmosphere of any system and generally can arise from such sources as materials of construction, vacuum pump oils and greases. Energetic radiation can be photons, electrons, or ions. This invention finds particular utility in those lithographic processes that employ highly energetic radiation such as extreme ultravoilet radiation and thus present a significant potential for contamination and, as a consequence, degradation of the performance of critical components.

While the process of the present invention is illustrated by application to extreme ultraviolet (EUV) lithography, and particularly to the mitigation of one common form of contamination prevalent therein, oxidation, its use is not limited to lithographic operations or elimination of oxidation but is contemplated to be applicable generally.

The process of the present invention is illustrated and explained by reference to Fig. 2, which shows a Si surface 210 of a Mo/Si multilayer mirror. Generally, water vapor will be present in any system, particularly an unbaked vacuum system. Thus, adventitious water vapor arises from outgassing of various system components and these water vapor molecules can be adsorbed onto any surface, such as illustrated by Fig. 2. Subjecting surface 210 to high energy radiation, such as by EUV radiation, can cause secondary electrons to be ejected from surface 210. As discussed above, these electrons can react with the adsorbed water molecules causing them to dissociate into reactive oxygen species that will, in turn, react with the Si surface. Prior to exposing surface 210 to incident radiation a small amount of a hydrocarbon gas that will also bind to surface 210 is admitted to the system. In the example illustrated by Fig. 2, the hydrocarbon gas is ethanol (C₂H₅OH). As was the case with bound water vapor, C₂H₅OH molecules bound to surface 210 will also be dissociated by the secondary electrons ejected from that surface. Reactive carbon fragments from the dissociated C₂H₅OH can react with reactive oxygen species on surface 210 to form volatile products such as CO and CO₂. In this way reactive oxygen species that could oxidize the Si surface and degrade its reflectivity are eliminated.

A demonstration of the ability of the novel process described herein to eliminate surface contamination caused by exposure of adventitious molecular species to high energy radiation is given by the following examples.

### EXAMPLE 1

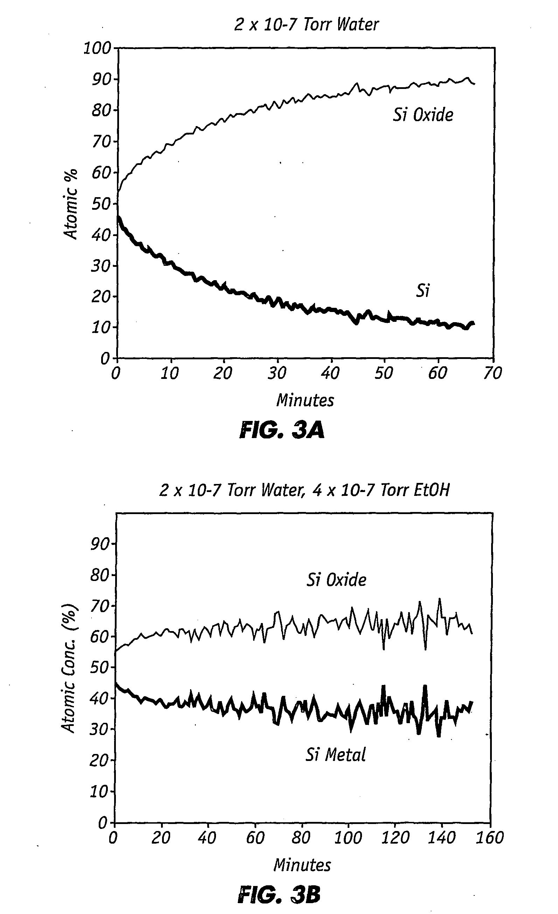

Initially, a Si-terminated multilayer mirror was exposed to an electron beam current density of about 5 µA/mm² at a beam energy of 2 keV in the presence of about 2x10⁻⁷ Torr of water vapor. The chemical composition of the surface of the mirror was monitored as a function of time. The Auger peak heights (which reflect the surface composition) of Si and SiO₂ are shown in Fig. 3A. It can be seen that the composition of the surface changed rapidly from Si to SiO₂ as oxidation progressed with a corresponding degradation in reflectivity.

The experiment above was repeated except that about 4x10⁻⁷ Torr of ethanol was added to the 2x10⁻⁷ Torr of water vapor the environment contained. As before, the chemical composition of the surface of the mirror was monitored as a function of time and the results are shown in Fig. 3B. It can be seen that, in contrast to the case where only water vapor was present, there is only a very small amount of SiO₂ present on the Si mirror surface; an amount consistent with the native oxide film typically found on Si. Further, post exposure analysis of the surface of the exposed mirror surface showed the presence of a film of graphitic carbon about 5 A thick.

It is the presence of a native oxide film on Si that determines the choice of the gas phase molecules used to protect against surface contamination. Recalling that one important prerequisite for the choice of gas phase molecules is that these molecules must first bind to the surface to be protected so that dissociation by secondary electron emission can take place, thereby liberating reactive species on the surface itself. Consequently, the preferred hydrocarbon molecules are those that will bind to native surface constituents, for example, a polar, hydroxylated film such as can be found on the surfaces of glasses, metals, and silicon. Therefore, hydrocarbon molecules containing such polar functional groups as ketones, aldehydes, esters, alcohols, amines, thiols, and carboxylic acids that will bind well to hydroxylated surfaces are preferred. It has been shown that non-hydrogen bonding hydrogen molecules, such as ethane, cannot confer any protection from oxidation to Si surfaces, presumably because these non-polar molecules cannot bind to the Si surface, and by analogy to any hydroxylated surface. Moreover, because the sticking coefficients for both ethanol and water vapor on a graphitic carbon surface are very small the growth of the graphitic carbon film produced when ethanol was used to provide oxidation protection tends to be self-limiting to a thickness of about 5 Å. Thus, the use of ethanol cannot lead to the formation of a catastrophically thick carbon layer, which itself would be undesirable. The self-limiting behavior leads to a large process latitude for the prevention method.

### EXAMPLE 2

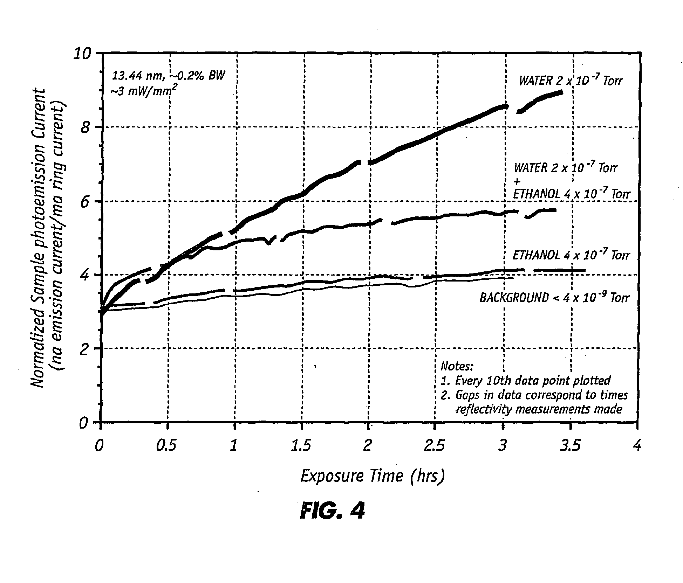

A Si-terminated Mo/Si mirror was exposed to 13.4 nm EUV radiation at a power level of about 7 mW/mm². The mirror was exposed to four different exposure conditions and the secondary electron emission was plotted as a function of time in Fig. 4. The exposure conditions were: background pressure (about 4x10⁻⁹ Torr); ethanol alone at a pressure of 4x10⁻⁷ Torr; water vapor alone at a pressure of 2x10⁻⁷ Torr; and a mixture of ethanol (4x10⁻⁷ Torr) and water vapor (2x10⁻⁷ Torr). Secondary electron emission has been shown to be a useful monitor of the surface processes because the onset of oxidation is signaled by a very rapid increase in secondary electron emission that is due to EUV absorption by oxygen with subsequent emission of secondary electrons. On the other hand, carbon deposition is signaled by a decrease in secondary electron emission due to the poor secondary electron emission characteristics of carbon.

Referring now to Fig. 4, it can be seen that exposure of the Si surface to water vapor in the presence of EUV radiation is accompanied by a rapid increase in the secondary electron signal denoting the formation of an oxide film. However, when ethanol is admitted the increase in secondary electron signal attributable to surface oxidation is significantly reduced demonstrating that the introduced hydrocarbon (ethanol) limited oxidation of the terminal Si surface. Further adjustment in the water/hydrocarbon ratio could achieve a balance point where carbon deposition and oxidation would balance each other.

Those skilled in the art will appreciate the importance of not adversely impacting the transmission of radiation, particularly for lithographic applications, by added gaseous components. The present invention provides an important advantage in this regard since, as exemplified above, the partial pressures of the various added gaseous molecular species need be only as high as necessary to affect surface chemistry. The use of gas pressures up to about 1x10⁻⁵ Torr would generally be adequate to provide a protective effect for most contamination problems while having negligible impact on lithographic throughput or uniformity. By way of example, the transmission of EUV radiation at 13.4 nm through 2 meters of a water/ethanol gas mixture, with each component at a partial pressure of about 1x10⁻⁵ Torr would be reduced by only about 0.05%.

In summary, the present invention provides a process for reducing or eliminating contamination and oxidation of surfaces caused by the interaction of high energy radiation on adventitious impurities. In particular, the process disclosed here can be used for reducing or eliminating oxide films on surfaces, such as the surface of silicon mirrors. Most particularly, the present invention provides special advantage in removing or reducing surface contamination in those components, such as masks and imaging optics, used in lithographic applications.

## Claims

1. A process for eliminating contamination of surfaces exposed to radiation, comprising:
a) providing an enclosed space having a surface (210) disposed therein, wherein the atmosphere within the enclosed space contains contaminants wherein the contaminants are water molecules which are absorbed by the surface (210) and can dissociate in response to radiation flux to form reactive oxygen species that can oxidize the surface (210);
b) introducing a gas capable of binding to the surface and reacting with the atmospheric contaminants into the enclosed space wherein the gas introduced comprises hydrocarbon molecules that bind to the surface and can dissociate in response to radiation flux to form reactive carbon fragments that can react with reactive oxygen to form volatile products; and
c) subjecting the contents of the enclosed space to extreme ultraviolet radiation.

2. The process of claim 1 wherein step (a) comprises providing an enclosed space having a lithographic surface (210) disposed therein wherein the enclosed space is at subatmospheric pressure.

3. The process of claim 1 wherein the gas is ethanol and a self-limiting coating of graphitic carbon film on the surface (210) is formed.

4. The process of any preceeding claims 1-2, wherein the hydrocarbon molecules contain at least one functionality selected from the group that includes ketones, aldehydes, esters, alcohols, amines, thiols, and carboxylic acids.

5. The process of claim 4, wherein the gas comprises ethanol.

6. The process of any preceding claims 1-5, wherein the partial pressure of the gas is less than about 10⁻⁵ Torr.

7. The process of any preceding claim wherein the surface (210) is a multilayer mirror.

## Patentansprüche

1. Verfahren zum Beseitigen der Verunreinigung von Oberflächen, die Strahlung ausgesetzt sind, wobei das Verfahren umfasst:
a) Bereitstellen eines geschlossenen Raums mit einer darin angeordneten Oberfläche (210), wobei die Atmosphäre innerhalb des geschlossenen Raums Verunreinigungen enthält, wobei die Verunreinigungen Wassermoleküle sind, die von der Oberfläche (210) absorbiert werden und in Reaktion auf einen Strahlungsfluss dissoziieren können, um eine reaktionsfähige Sauerstoffart zu bilden, die die Oberfläche (210) oxidieren kann;
b) Einleiten eines Gases, das sich an die Oberfläche binden kann und mit den Atmosphärenverunreinigungen in dem geschlossenen Raum reagieren kann, wobei das eingeleitete Gas Kohlenwasserstoffmoleküle umfasst, die sich an die Oberfläche binden und die in Reaktion auf den Strahlungsfluss dissoziieren können, um reaktionsfähige Kohlenstofffragmente zu bilden, die mit reaktionsfähigem Sauerstoff reagieren können, um flüchtige Produkte zu bilden; und
c) Aussetzen des Inhalts des geschlossenen Raums extremer Ultraviolettstrahlung.

2. Verfahren nach Anspruch 1, bei dem der Schritt (a) das Bereitstellen eines geschlossenen Raums mit einer darin angeordneten Lithographieoberfläche (210) umfasst, wobei der geschlossene Raum auf einem Druck unterhalb des Luftdrucks ist.

3. Verfahren nach Anspruch 1, bei dem das Gas Ethanol ist und auf der Oberfläche (210) eine selbstbegrenzende Beschichtung aus einem Graphitkohlenstofffilm gebildet wird.

4. Verfahren nach einem der vorhergehenden Ansprüche 1 bis 2, bei dem die Kohlenwasserstoffmoleküle wenigstens eine Funktionalität enthalten, die aus der Gruppe ausgewählt wird, die Ketone, Aldehyde, Ester, Alkohole, Amine, Thiole und karbozyklische Säuren enthält.

5. Verfahren nach Anspruch 4, bei dem das Gas Ethanol umfasst.

6. Verfahren nach einem der vorhergehenden Ansprüche 1 bis 5, bei dem der Partialdruck des Gases kleiner als etwa 10⁻⁵ Torr ist.

7. Verfahren nach einem vorhergehenden Anspruch, bei dem die Oberfläche (210) ein Mehrschichtspiegel ist.

## Revendications

1. Procédé pour éliminer la contamination de surfaces exposées à un rayonnement, comprenant :
a) la fourniture d'un espace clos ayant une surface (210) disposée dans celui-ci, l'atmosphère à l'intérieur dudit espace clos contenant des contaminants, lesquels contaminants sont des molécules d'eau qui sont absorbées par la surface (210) et peuvent se dissocier en réponse à un flux de rayonnement pour former des espèces oxygénées réactives qui peuvent oxyder la surface (210) ;
b) l'introduction d'un gaz apte à se lier à la surface et à réagir avec les contaminants de l'atmosphère jusque dans l'espace clos, lequel gaz introduit comprend des molécules hydrocarbonées qui se lient à la surface et peuvent se dissocier en réponse à un flux de rayonnement pour former des fragments carbonés réactifs qui peuvent réagir avec l'oxygène réactif et former des produits volatils ; et
c) la soumission du contenu de l'espace clos à un rayonnement ultraviolet extrême.

2. Procédé selon la revendication 1, dans lequel l'étape (a) comprend la fourniture d'un espace clos ayant une surface lithographique (210) disposée dans celui-ci, dans lequel l'espace clos est à pression sub-atmosphérique.

3. Procédé selon la revendication 1, dans lequel le gaz est l'éthanol et un revêtement auto-limitant de film de carbone graphitique sur la surface (210) est formé.

4. Procédé selon l'une quelconque des revendications 1-2 précédentes, dans lequel les molécules hydrocarbonées contiennent au moins une fonctionnalité choisie dans le groupe qui inclut les cétones, les aldéhydes, les esters, les alcools, les amines, les thiols et les acides carboxyliques.

5. Procédé selon la revendication 4, dans lequel le gaz comprend l'éthanol.

6. Procédé selon l'une quelconque des revendications 1 à 5 précédentes, dans lequel la pression partielle du gaz est inférieure à environ 10⁻⁵ torr.

7. Procédé selon l'une quelconque des revendications précédentes, dans lequel la surface (210) est un miroir multicouches.
